# EUROPEAN PATENT APPLICATION

(11) **EP 4 650 875 A1**
(43) Date of publication of application: **19.11.2025**
(21) Application number: 24175527.1
(22) Date of filing: 13.05.2024
(51) Int. Cl.: G03F 7/20, G02B 13/22, G02B 27/00, G02B 27/42

(54) **ILLUMINATION UNIFORMITY CORRECTION APPARATUS WITH A TRANSMISSIVE CORRECTION PLATE WITH A VARYING PARAMETER PROFILE**

(71) Applicant: ASML Netherlands B.V., 5500 AH Veldhoven (NL)
(72) Inventor: VAN GORKOM, Ramon, 5500 AH Veldhoven (NL)
(74) Representative: ASML Netherlands B.V.

(57) **Abstract**

There is provided an illumination uniformity correction apparatus for use in an illumination system comprising: at least one transmissive correction plate comprising a varying parameter profile configured to make a local angular redistribution of radiation transmitted through said at least one transmissive correction plate.

## Description

### FIELD OF THE INVENTION

The present invention relates to a uniformity correction module. The present invention also relates to a corresponding method of varying a local angular distribution of radiation using a uniformity correction module.

### BACKGROUND OF THE INVENTION

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") of a patterning device (e.g., a mask or reticle) supported by a mask support onto a layer of radiation-sensitive material (resist) provided on a substrate (e.g., a wafer). A substrate support (e.g., a wafer table or wafer holder) constructed to hold a substrate (e.g., a resist coated wafer) can be moved accurately, e.g., so as to position different target portions in the path of a radiation beam at a focused and aligned position, herewith to project the pattern on the substrate.

It is desirable to provide control over various properties of a radiation beam that is used in a lithographic apparatus to project a pattern onto a substrate. For example, it is desirable to monitor an energy of the radiation beam to allow control over a dose of radiation that is delivered to the substrate. Furthermore, it is desirable to provide control over the shape (i.e., the spatial distribution) of the radiation beam in a plane of the patterning device. In addition, it is desirable to provide control over the angular distribution of the radiation beam in a plane of the patterning device.

It may be desirable to provide new, alternative lithographic apparatus and/or methods that at least partially addresses one or more problems associated with prior art arrangements whether identified herein or otherwise.

### SUMMARY OF THE INVENTION

According to a first aspect of the present disclosure there is provided an illumination uniformity correction apparatus for use in an illumination system comprising: at least one transmissive correction plate comprising a varying parameter profile configured to make a local angular redistribution of radiation transmitted through said at least one transmissive correction plate.

The above and other aspects of the invention will be understood from a consideration of the examples described below.

### BRIEF DESCRIPTION OF THE DRAWINGS

Embodiments of the invention will now be described, by way of example only, with reference to the accompanying schematic drawings, in which:
Figure 1 depicts a schematic overview of a lithographic apparatus;
Figure 2 depicts a telecentricity fingerprint profile;
Figure 3 depicts a schematic overview of aspects of an illumination system;
Figure 4a depicts a perspective view of a typical uniformity correction module.
Figure 4b depicts an end view of a typical uniformity correction module.
Figure 4c depicts a side view of a typical uniformity correction module.
Figure 5a depicts a perspective view of a uniformity correction module in accordance with some embodiments.
Figure 5b depicts an end view of a uniformity correction module in accordance with some embodiments.
Figure 5c depicts a side view of a uniformity correction module in accordance with some embodiments.
Figure 6a depicts a perspective view of a uniformity correction module in accordance with some embodiments.
Figure 6b depicts a first end view end view of a uniformity correction module in accordance with some embodiments.
Figure 6c depicts a side view of a uniformity correction module in accordance with some embodiments
Figure 6d depicts a second end view uniformity correction module in accordance with some embodiments.

### DETAILED DESCRIPTION

In the present document, the terms "radiation" and "beam" are used to encompass all types of electromagnetic radiation, including ultraviolet radiation (e.g., with a wavelength of 365, 248, 193, 157 or 126 nm).

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

To clarify the invention, a Cartesian coordinate system is used. The Cartesian coordinate system has three axis, i.e., an x-axis, a y-axis and a z-axis. Each of the three axis is orthogonal to the other two axis. A rotation around the x-axis is referred to as an Rx-rotation. A rotation around the y-axis is referred to as an Ry-rotation. A rotation around about the z-axis is referred to as an Rz-rotation. The Cartesian coordinate system is not limiting the invention and is used for clarification only.

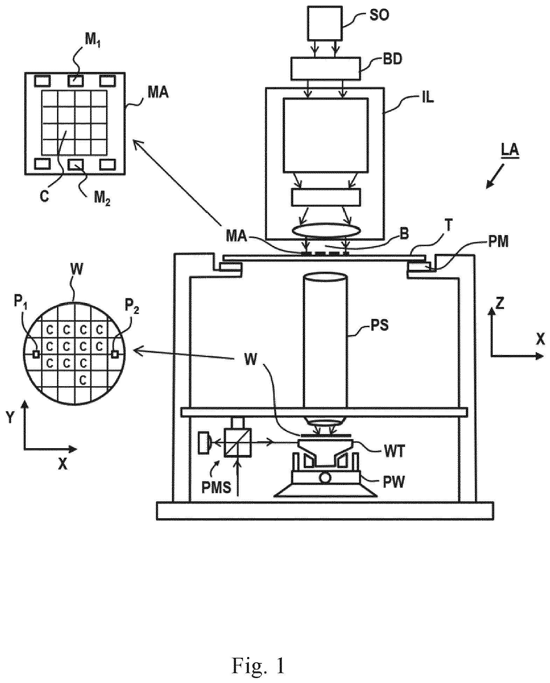

Figure 1 schematically depicts a lithographic apparatus LA. The lithographic apparatus LA includes an illumination system (also referred to as illuminator) IL configured to condition a radiation or light beam B (e.g., UV radiation, DUV radiation or EUV radiation), a mask support (e.g., a mask table) MT constructed to support a patterning device (e.g., a mask) MA and connected to a first positioner configured to accurately position the patterning device MA in accordance with certain parameters, a substrate support (e.g., a wafer table) WT constructed to hold a substrate (e.g., a resist coated wafer) W. A second positioner configured to accurately position the substrate support in accordance with certain parameters may be arranged. A projection lens system (e.g., a refractive projection lens system) PL configured to project a pattern imparted to the radiation beam B by patterning device MA (a patterned projection beam) onto a target portion (e.g., comprising one or more dies) of the substrate W.

In operation, the illumination system IL receives a radiation beam from a radiation source SR, e.g., via a beam delivery system. The illumination system IL may include various types of optical components, such as refractive, reflective, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection lens system" PL used herein should be broadly interpreted as encompassing various types of projection systems, including refractive, reflective, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PL.

The lithographic apparatus LA may be of a type wherein at least a portion of the substrate may be covered by a liquid having a relatively high refractive index, e.g., water, so as to fill a space between the projection system PL and the substrate W - which is also referred to as immersion lithography. More information on immersion techniques is given in US6952253, which is incorporated herein by reference.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PL or a property of the radiation beam B. The measurement stage may hold multiple sensors. The cleaning device may be arranged to clean part of the lithographic apparatus, for example a part of the projection system PL or a part of a system that provides the immersion liquid. The measurement stage may move beneath the projection system PL when the substrate support WT is away from the projection system PL.

In operation, the radiation beam B is incident on the patterning device (or mask) MA which is held on the mask support MT, and is patterned by the pattern (design layout) present on patterning device MA. Having traversed the mask MA, the radiation beam B passes through the projection system PL, which focuses the beam onto a target portion of the substrate W. With the aid of the second positioner and a position measurement system, the substrate support WT can be moved accurately, e.g., so as to position different target portions in the path of the radiation beam B at a focused and aligned position. Similarly, the first positioner and possibly another position sensor (which is not explicitly depicted in Figure 1) may be used to accurately position the patterning device MA with respect to the path of the radiation beam B. Patterning device MA and substrate W may be aligned using mask alignment marks and substrate alignment marks. Although the substrate alignment marks occupy dedicated target portions, they may be located in spaces between target portions. Substrate alignment marks are known as scribe-lane alignment marks when these are located between the target portions.

A masking device MD is provided for selectively shielding parts of the patterning device MA from the radiation beam B. In other embodiments, not illustrated by Figure 1, the masking device MD may be provided to selectively shield parts of the patterned projection beam. As is illustrated in Figure 1, relay optics (or relay lens) RL is provided for projecting the radiation that passes through the masking device to the patterning device MA.

It will be appreciated by the skilled person that features of different aspects of the invention, as disclosed above, may be combined together.

It is known that a lithographic apparatus (e.g., such as described in Figure 1) may have an associated telecentricity fingerprint that may be imparted onto a radiation beam resulting in a non-telecentric angular distribution of radiation (i.e., a "center of gravity" of the angular distribution of radiation deviates significantly from an optical axis of the illuminator) comprised in said radiation beam, also known as a telecentricity profile. Said telecentric fingerprint may be a result of illuminator design, projection lens design, alignment of the illuminator with respect to other system parts and/or alignment of the radiation beam with respect to the illuminator.

The Illuminator IL may direct radiation to the patterning device MA in an illumination region, also known as a slit or illumination slit. An angularly resolved spectrum of radiation may be known as a pupil. There may be several negative effects associated with non-telecentricity. In some cases, the angles of incidence of radiation on a reticle and hence on a wafer may become asymmetric. This may have the effect that a side wall angle of a written feature may become asymmetric as well. This in turn may lead to critical dimension (CD) or overlay issues. Further, non-telecentricity may lead to an uneven focus through the slit (i.e., focus may vary from the center of the slit towards an edge of the slit), which may result in a pattern shift, creating overlay issues. If a pupil shape is such that either the created light is close to the numerical aperture (NA) of the system or diffracted light at the reticle is close to the NA, then shifting the light in the pupil may cause the light to be (partly) clipped. This also may lead to imaging and overlay issues.

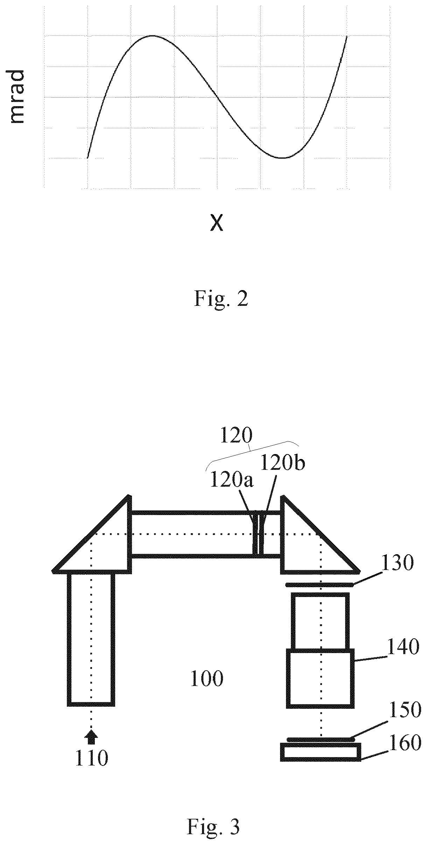

In some cases, it may be possible to correct for non-telecentricity by modifying the angular distribution of the radiation beam in a manner that may counteract a telecentricity profile of the radiation beam (e.g., caused by said telecentricity fingerprint). Referring to Figure 2, when observed across said illumination region in a non-scanning direction in a plane parallel to the substrate plane, i.e., the X direction, said telecentricity profile may comprise a first polynomial distribution, also known herein as an n^{th} order telecentricity variation through slit. Figure 2 shows a purely exemplary 3^{rd} order polynomial telecentricity distribution (i.e., said first polynomial distribution) in the X direction. Said first polynomial distribution may be counteracted by modifying the angular distribution of said radiation beam in accordance with a second polynomial distribution determined according to the integral of the first polynomial distribution. In a specific example, it may be possible to counteract a telecentricity fingerprint comprising a 3^{rd} order polynomial profile by modifying the radiation beam imparted with said fingerprint according to a 4^{th} order polynomial profile. It is known to provide a wedge (i.e., a wedge prism) disposed within the illuminator system or at a reticle in order to modify the angular distribution of a radiation beam to provide such telecentricity counteraction or correction. Alternatively, correction may be provided on a reticle masking (ReMa) lens, e.g., a ReMa lens shaped to provide said telecentric counteraction (i.e., comprising a wedge shape). US2001/0012101A1 (which is incorporated herein by reference) discloses a uniform wedge-like telecentricity corrector disposed above a reticle. Generally speaking, any telecentric profile may be fit with a polynomial of sufficient order and hence may be corrected.

A static telecentricity corrector having a uniformity correction by using a local refractive index gradient is disclosed in US2009/0323040, which is incorporated herein by reference.

Providing a correction profile on a wedge-like element (or the ReMa-lens) may have limited use. That is, if there are different telecentricity profiles to correct (e.g., due to different projection lenses) then different wedge-plates (or e.g., ReMa lenses) would be required to counteract each different telecentricity profile. In addition, with a fixed correction profile, a lithographic apparatus will perform all exposures with the same fixed profile, which in some cases may not be advantageous. Changing the projection lens to reduce non-telecentricity has the disadvantage that other key performance indicators (KPIs) of the projection lens (e.g., aberrations) may worsen.

Another solution may be to determine a reticle comprising a profile to counteract said non-telecentricity. The advantage of said reticle is that different pattern per reticle may be determined. Thus, it is possible to select whether or not said reticle correction is advantageous for a specific use case. A disadvantage is that this will result in a reticle with a non-flat reticle backside that may not be compatible with a reticle-writer. Furthermore, said reticle would lead to a different performance with different projection lenses. Having a non-flat reticle may lead to focus differences owing to the manner in which said reticle would require to be clamped. A further disadvantage of a non-flat reticle is that having a difference in thickness across the reticle may be more difficult to keep the front side of the reticle flat compared to a flat reticle.

A lithography apparatus may comprise a uniform control module (unicom) (e.g., comprised in an illuminator of a lithography apparatus). A unicom may comprise an optical filter (e.g., a neutral density or gray-filter), the function of which is to adjust illumination intensity near the reticle to ensure slit uniformity (i.e., light intensity uniformity, or dose uniformity across said slit). The filter generally comprises at least one (e.g., two) movable plates comprising an intensity transmission profile, for example transmissive correction plates, that may be moved along a Y scanning axis (where the Y direction is perpendicular to the X direction in said plane parallel to the substrate plane) in order to adjust the illumination intensity.

Figure 3 shows a simplified schematic of a purely exemplary illuminator 100 arrangement comprising a projection system 140, patterning device 130, wafer support 160 and wafer 150, that may be used to describe a location of said unicom 120 within said illuminator 100. Many components have been omitted from the illuminator 100 for ease of understanding, and the simplified schematic merely serves to assist in visualising the location of said unicom 120. Said illuminator 100 may comprise a radiation path 110. The illuminator 100 may be operable to guide a radiation beam (not shown) along said radiation path 110 and through unicom 120. Said unicom 120 may be disposed in a plane of the illuminator 100 that is conjugate to that of patterning device 130. Such a plane may be referred to as a field plane. In this example, unicom 120 comprises a first transmissive correction plate 120a and a second transmissive correction plate 120b. As described above, at least one of first and second transmissive correction plates 120a and 120b may be moveable along a Y scanning axis in order to adjust an illumination intensity of a radiation beam propagating along radiation path 110. An alternative location for first transmissive correction plate 120a and second transmissive correction plate 120b may be directly above patterning device 130. Patterning device 130 (e.g., a reticle or mask) may impart a pattern to said radiation beam to provide a patterned radiation beam, and projection system140 may guide said patterned radiation beam towards a wafer 150 positioned on a wafer support 160.

The inventor has determined that at least one of said unicom transmissive correction plates may be modified, or adapted, to comprise a varying thickness profile. Said varying thickness profile (i.e., a cross-sectional profile having a non-constant thickness) may be configured to counteract a non-telecentricity in a radiation beam, i.e., by making local angular redistributions of said radiation beam comprising local angular redistributions of radiation. Providing a transmissive correction plate having a varying thickness profile may be less expensive than adjusting a reticle. A further advantage is that said thickness profile may only require to be determined once (i.e., when said plate is fabricated). In some examples, a varying thickness profile in an X direction may be different for different Y positions.

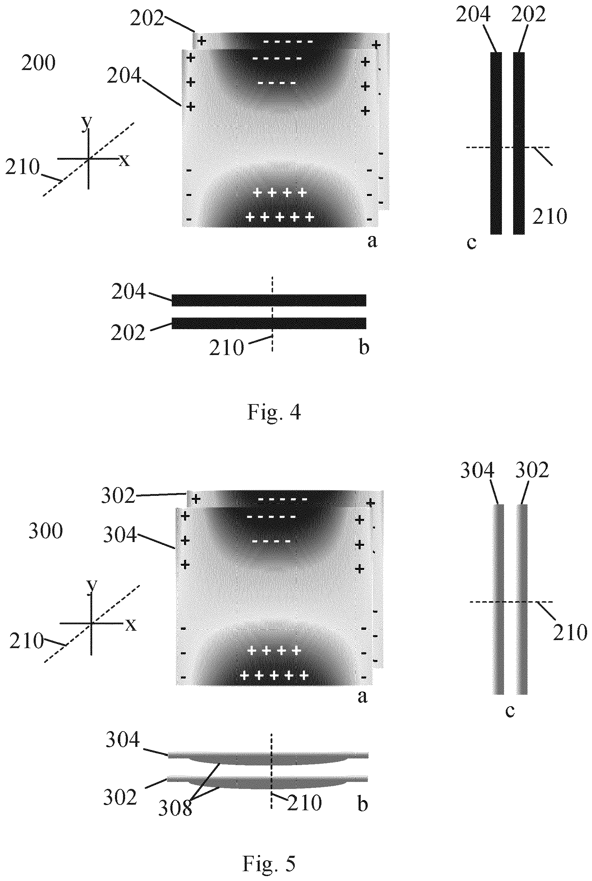

A typical unicom is described with reference to Figures 4a, 4b and 4c. In this example, the unicom 200 shown in Figure 4a may comprise a first transmissive correction plate 202 and a second transmissive correction plate 204. Other examples (not shown) may comprise a single transmissive correction plate. The positive (+) and negative (-) symbols are purely illustrative and serve to indicate areas of the first and/or second transmissive correction plates 202 204 that may be more or less transmissive to radiation respectively (i.e., the intensity transmission profile of said transmissive correction plates). Said intensity transmission profile changes gradually between the positive and negative areas. In operation, the first and second transmissive correction plates 202 204 lie in a plane perpendicular to an optical axis 210 of a radiation beam transmitted through said correction plates 202 204. By varying a Y position of the first transmissive correction plate 202 and/or second transmissive correction plate 204 with respect to one another, a varying transmission intensity profile may be provided, thus allowing adjustment of an intensity of a radiation beam transmitted through said unicom 200. In typical use cases, this may allow control of the uniformity of a radiation beam intensity. Said first and second transmissive correction plates 202 204 have a constant thickness profile, i.e., when observed by end view (i.e., in the XY-plane, looking into the Y-axis) shown in Figure 4b and side view (i.e., in the XY-plane, looking into the X-axis) shown in Figure 4c. The shading across each of the first transmissive correction plates 202 and the second transmissive correction plate 204 is a graphic representation of said transmission intensity profile of said first and second transmissive correction plates 202 204.

An adapted unicom in accordance with aspects of the present disclosure is described with reference to Figures 5a, 5b and 5c. In the example shown in Figure 5a, the adapted unicom 300 may comprise a first adapted transmissive correction plate 302 and a second adapted transmissive correction plate 304. In contrast to the first and second transmissive correction plates 202 204 of unicom 200 that comprise a constant thickness profile, first adapted transmissive correction plate 302 and/or adapted transmissive correction plate 304 (also referred to herein as adapted plates) comprise a varying thickness profile 308. In some examples (not shown) an adapted unicom 300 may comprise one adapted transmissive correction plate 302 304 comprising a varying thickness profile 308. A shape, or contour, of said varying thickness profile 308 may be determined to counteract an *n*^{th} order telecentricity variation through slit of a radiation beam incident on said adapted unicom 300. In other words, said varying thickness profile 308 may be operable to make local angular redistributions a radiation beam transmitted through said adapted unicom 300. In some examples, a shape of the varying thickness profile 308 may be based on a telecentricity fingerprint of a lithographic apparatus comprising said adapted unicom 300. Said first adapted transmissive correction plate 302 and second adapted transmissive correction plate 304 comprising said varying thickness profile 308 are also shown in end view Figure 5b and side view Figure 5c.

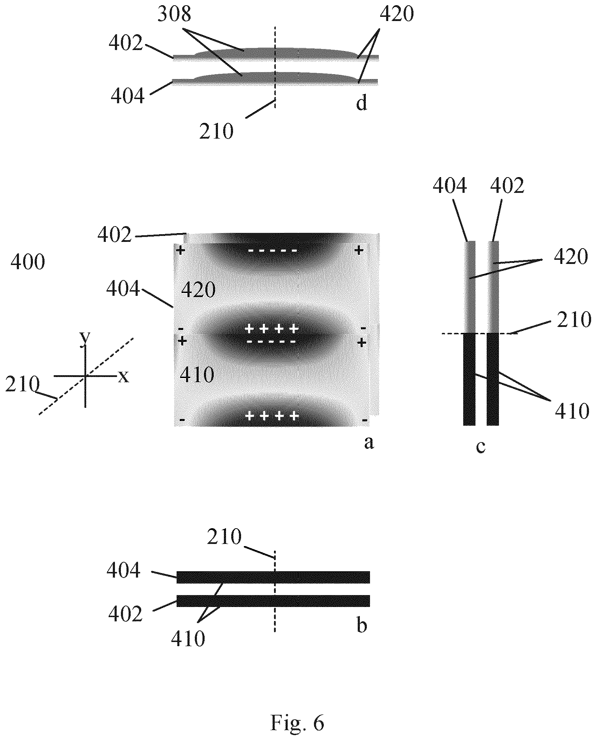

Another example of an adapted unicom is described with reference to Figures 6a, 6b, 6c and 6d. In this example, the unicom 400 shown in Figure 6a may comprise at least one adapted plate (e.g., adapted first plate 402 and/or adapted second plate 404) comprising a first section 410 and a second section 420. As such, where there are two adapted plates, one or both may comprise two (or more) sections. The first section 410 (e.g., extending along 20%, 30%, 40%, 50%, 60%, 70% or 80% of the plate in the Y direction and the full length in the X-direction) of adapted first plate 402 and/or adapted second plate 404 may have a uniform thickness profile (e.g., when observed by first end view Figure 6b similar to first plate 202 and second plate 204), and the second section 420 of adapted first plate 402 and/or adapted second plate 404 (e.g., extending along 80%, 70%, 60%, 50%, 40%, 30% or 20% of the plate in the Y direction and the full length in the X-direction) may comprise a varying thickness profile 308. In this way, the adapted unicom 400 may comprise a plurality of different thickness profiles corresponding to different angular distributions that may be selected, e.g., based on a telecentricity fingerprint or a parameter of an exposure. Said first adapted transmissive correction plate 402 and second adapted transmissive correction plate 404 comprising a first section 410 and a second section 420 are also shown in first end view Figure 6b (i.e., from the perspective of looking in towards the optical axis 210 from an end comprising the first section 410), second end view Figure 6d (i.e., from the perspective of looking in towards the optical axis 210 from an end comprising second section 420) and side view Figure 6c.

Different thickness profiles may be selected by moving the adapted first plate 402 and/or the adapted second plate 404 with respect to each other in the Y direction to align first section 410 and/or second section 420 comprised in the adapted first plate 402 with first section 410 and/or second section 420 comprised in the adapted second plate 404 along optical axis 210.

The adapted first plate 402 and the adapted second plate 404 (i.e., corresponding to the second section 420) may comprise the same varying thickness profile 308. In some examples, the adapted first plate 302 may comprise a first varying thickness profile 308 and the adapted second plate 304 may comprise a second varying thickness profile 308. Each section 410 420 comprised in each of adapted first plate 402 and the adapted second plate 404 may comprise a different varying thickness profile. Any combination of sections 410 420 comprising a varying thickness profile 308 and/or a uniform thickness profile may be envisaged based on any particular use case.

More generally, an adapted unicom may comprise one or more adapted plates, wherein at least one of the one or more adapted plates comprises two or more sections, and wherein each section has a respective different thickness profile, or where at least two of the thickness profiles are the same. For example, at least one adapted plate may comprise first, second and third sections. Each first, second and third section may comprise a different thickness profile. This example may provide *n*² combinations of thickness profiles, wherein *n* corresponds to a total number of sections across the first and second adapted plates 302 304.

Although the examples shown in Figure 5 and Figure 6 comprise a first adapted transmissive correction plate 302 402 and a second adapted transmissive correction plate 304 404, other examples may comprise any number of one or more adapted transmissive correction plates having a varying thickness profile as required by any particular use case. Said adapted unicom 300 400 may further comprise any number of typical transmissive correction plates as required (i.e., having a constant thickness profile). In the case where adapted unicom 300 400 comprises one adapted transmissive correction plate 302 304 402 404, said adapted transmissive correction plate 302 304 402 404 may provide a static correction profile.

When adapted unicom 300 400 comprises more than one adapted transmissive correction plate, for example the adapted unicom shown in either Figure 5 and Figure 6, said adapted first and/or second plate may be moveable in a Y direction in order to align any sections comprised in the first plate with any sections comprised in the second plate along optical axis 210.

In any or all examples, a shape of said varying thickness profile 308 may be determined to counteract an *n*^{th} order telecentricity variation through slit of a radiation beam incident on said adapted unicom 300 400. In some examples, a shape of the varying thickness profile 308 may be based on a telecentricity fingerprint of a lithographic apparatus comprising said adapted unicom 300 400.

In some aspects there may be provided a method of varying a local angular distribution of radiation using the adapted unicom 300 400 described herein.

Said method may comprise providing a radiation beam comprising an angular distribution of radiation and transmitting said radiation beam through at least one transmissive correction plate 302 304 402 404 of adapted unicom 300 400, wherein a varying thickness profile 308 of the at least one transmissive correction plates 302 304 402 404 may be configured based on the angular distribution. That is, said varying thickness profile 308 may be determined to change the angular distribution of radiation of the radiation beam.

In some examples, the varying thickness profile 308 of the at least one transmissive correction plate 302 304 402 404 may be configured to counteract an nth order telecentricity variation through slit of the radiation beam.

More generally, said varying thickness profile may be considered to be a varying parameter profile. Thus, a transmissive correction plate that does not comprise a varying thickness profile may be considered more generally to comprise a non-varying parameter profile.

All of the examples of varying thickness profile 308 described herein may be considered examples of a varying parameter profile. Instead of a varying thickness profile, the varying parameter profile may instead comprise varying profiles of another parameter such as a refractive index. For example, the at least one transmissive correction plate 302 304 402 404 may comprise a varying refractive index, also known as a graded refractive index, wherein a refractive index of said at least one transmissive correction plate 302 304 402 404 may vary within a plane perpendicular to an optical axis of said at least one transmissive correction plate 302 304 402 404 (i.e., radially from the optical axis) to make a local angular redistribution of radiation transmitted through said at least one transmissive correction plate 302 304 402 404.

In some examples, said varying parameter profile 308 may comprise a varying refractive profile and/or a varying diffractive profile. That is, said varying parameter profile 308 may be configured to make a local angular redistribution of radiation transmitted through said at least one transmissive correction plate by refraction and/or diffraction of said radiation. This may be realized, for example, by providing a physical profile variation (e.g., a varying thickness) on the at least one transmissive correction plate 302 304 402 404 that may provide a varying level of refraction and/or diffraction of radiation transmitted through the at least one transmissive correction plate 302 304 402 404.

In yet another example of a varying parameter profile, the at least one transmissive correction plate 302 304 402 404 may comprise a varying optical interference pattern such as provided by a holographic optical element (HOE), which in some examples may comprise an optical diffuser such as a diffraction grating. Said varying optical interference pattern may be configured to make a local angular redistribution of radiation transmitted through said at least one transmissive correction plate 302 304 402 404.

More generally, in any or all examples, said varying parameter profile may be considered to comprise a polynomial distribution. For example, said varying parameter profile may be determined to counteract an *n*^{th} order telecentricity variation through slit of a radiation beam incident on said adapted unicom 300 400.

In any or all examples, the at least one transmissive correction plate 302 304 402 404 may compromise an anti-reflective coating, which may have angle dependent anti-reflective properties (i.e., dependent on an angle of incidence of a radiation beam incident on said anti-reflective coating). Said anti-reflective coating may be adjusted based on a local angle of the at least one adapted transmissive correction plate 302 304 402 404 in order to compensate for differences in an angle of incidence caused by a varying parameter profile of the at least one transmissive correction plate 302 304 402 404.

Said adapted unicom 300 400 may be provided with a plurality of transmissive correction plates 302 304 402 404 comprising a plurality of sections 410 420, wherein at least one of the plurality of sections 410 420 comprises a varying parameter profile 308. Each of said plurality of sections 410 420 may each comprise a similar transmission intensity profile. Said method may further comprise varying a Y position of at least one of the plurality of transmissive correction plates 302 304 402 404 to align sections 410 420 of the plurality of transmissive correction plates along an optical axis. Said varying in the Y direction may be based on the angular distribution of the radiation beam.

The angular distribution may correspond to a telecentricity profile of the radiation beam. Accordingly, the plurality of transmissive plates may be aligned such that a resulting cumulative varying parameter profile of the aligned plates may counteract said telecentricity profile of the radiation beam.

In any of the above examples, at least one of said plurality of transmissive correction plates 302 304 402 404 may be moveable in a non-scanning, or X direction.

In any of the above examples, said adapted unicom 300 400 may comprise at least one rotatable correction plate (not shown). Said at least one rotatable correction plate may comprise a varying parameter profile 308 and/or a plurality of sections 410 420 in accordance with previous examples. Said at least one rotatable correction plate may be rotatable around optical axis 210 within the XY-plane.

In examples wherein the transmissive correction plate comprises a plurality of sections (e.g., sections 410 420, said plurality of sections may be disposed adjacently in a non-scanning X direction and/or disposed adjacently in a scanning Y direction.

Said unicom 300 400 may be configured to make local angular redistributions of radiation transmitted through said unicom 300 400 whilst maintaining an intensity uniformity of said radiation beam. That is, a function of said unicom 300 400 may be to provide radiation having a uniform intensity profile. Movement of a correction plate comprised in said unicom 300 400 (e.g., adapted transmissive correction plate 302 304 402 404) in, for example, the Y direction may lead to a change in the transmission intensity profile of said unicom 300 400. By providing a unicom having rotational and/or X direction movement capabilities, said unicom may be arranged to make local angular redistributions of transmitted radiation whilst maintaining said transmission intensity profile.

In some aspects, there is provided a method of manufacturing a transmissive correction plate 302 304 402 404. Said method may comprising determining a telecentricity profile of a radiation beam in a lithographic apparatus. In some examples the telecentricity profile may be determined by measuring a pupil (i.e., angularly resolved radiation of the radiation beam) at a pinhole by a 2D sensor at wafer level, and determining a level of tilt of the pupil (i.e., how much a "center of gravity" of the angular distribution of radiation deviates from the optical axis of an illuminator of the lithographic apparatus).

The method may further comprise determining a correction profile based on the telecentricity profile in accordance with methods described herein (e.g., by determining the integral of a polynomial distribution representing said telecentricity profile).

The method may further comprise fabricating said transmissive correction plate 302 304 402 404, wherein a varying parameter profile 308 may be provided on said transmissive correction plate 302 304 402 404 based on the determined correction profile.

Said varying parameter profile 308 may be considered to comprise a polynomial distribution, e.g., in order to counteract said telecentricity profile of the radiation beam.

The term adapted transmissive correction plate is used herein to mean a transmissive correction plate that has been adapted, or configured, to make a local angular redistribution of radiation transmitted through said at least one transmissive correction plate.

Although specific reference may be made in this text to the use of a lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, or any apparatus that measures or processes an object such as a wafer (or other substrate) or mask (or other patterning device). These apparatus may be generally referred to as lithographic tools. Such a lithographic tool may use vacuum conditions or ambient (non-vacuum) conditions.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

Aspects of the invention are set out in the clauses below.
1. An illumination uniformity correction apparatus for use in an illumination system comprising:
   at least one transmissive correction plate comprising a varying parameter profile configured to make a local angular redistribution of radiation transmitted through said at least one transmissive correction plate.
2. The apparatus of clause 1 wherein the varying parameter profile comprises at least one of a varying thickness profile, a varying refractive index, a varying optical interference pattern, a varying diffractive profile and/or a varying refractive profile.
3. The apparatus of clause 1 or 2, wherein the at least one transmissive correction plate further comprises a plurality of adjacent sections, wherein at least one of the plurality of adjacent sections comprises a varying parameter profile.
4. The apparatus of any of clauses 1 to 3, wherein at least one of the plurality of adjacent sections comprises a non-varying parameter profile.
5. The apparatus of any preceding clause, wherein when the apparatus comprises two or more transmissive correction plates, said apparatus operable to vary a relative position of at least one of the two or more transmissive correction plates in order to align adjacent sections of each of the two or more transmissive correction plates along an optical axis of the illumination system.
6. The apparatus of clause 5, wherein the relative position of each of the two or more transmissive correction plates is variable in a scanning direction.
7. The apparatus of clause 5 or 6, wherein the relative position of the at least one transmissive correction plate is variable in a non-scanning direction.
8. The apparatus of any preceding clause, wherein said varying parameter profile or profiles are configured to counteract an nth order telecentricity variation through slit of radiation transmitted through said at least one transmissive correction plate.
9. The apparatus of any preceding clause, wherein the at least one transmissive correction plate is configured to be rotatable around an optical axis of the illumination system.
10. A method of varying a local angular distribution of radiation using the illumination uniformity correction apparatus of any of clauses 1 to 9 comprising:
   providing a radiation beam comprising an angular distribution of radiation,
   configuring a varying parameter profile of the at least one transmissive correction plate based on the angular distribution of radiation; and
   transmitting said radiation beam through the at least one transmissive correction plate of the illumination uniformity correction apparatus.
11. The method of clause 10, further comprising configuring the varying parameter profile of the at least one transmissive correction plate to counteract an nth order telecentricity variation through slit of the radiation beam.
12. The method of clause 10 or 11 further comprising,
   providing a plurality of transmissive correction plates comprising a plurality of sections, wherein at least one of the plurality of sections comprises a varying parameter profile; and
   varying a relative position of at least one of the plurality of transmissive correction plates to align sections of the plurality of transmissive correction plates along an optical axis of the illumination system.
13. The method of clause 12, wherein the varying a relative position is based on the angular distribution of radiation.
14. The method of clause 13, wherein the angular distribution of radiation corresponds to a telecentricity profile of the radiation beam.
15. An illumination system for a lithographic apparatus comprising the illumination uniformity correction apparatus of any of clauses 1 to 9.
16. A lithographic apparatus comprising the illumination system of clause 15.
17. A method of manufacturing a transmissive correction plate, the method comprising:
   determining an angular distribution of radiation comprised in a radiation beam in a lithographic apparatus, wherein the angular distribution of radiation comprises a telecentricity profile;
   determining a correction profile based on the telecentricity profile; and
   fabricating said transmissive correction plate, wherein a varying parameter profile is provided on said transmissive correction plate based on the determined correction profile.
18. The method of clause 17, wherein the varying parameter profile comprises at least one of a varying thickness profile, a varying refractive index, a varying optical interference pattern, a varying diffractive profile and/or a varying refractive profile.
19. The method according clause 17 or 18, wherein the varying parameter profile comprises a polynomial distribution.
20. The apparatus of any of clauses 1 to 9, wherein the varying parameter profile comprises a polynomial distribution.
21. The apparatus of any of clauses 1 to 9, wherein the at least one transmissive correction plate comprises a holographic optical element.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. An illumination uniformity correction apparatus for use in an illumination system comprising:
at least one transmissive correction plate comprising a varying parameter profile configured to make a local angular redistribution of radiation transmitted through said at least one transmissive correction plate.

2. The apparatus of claim 1 wherein the varying parameter profile comprises at least one of a varying thickness profile, a varying refractive index, a varying optical interference pattern, a varying diffractive profile and/or a varying refractive profile.

3. The apparatus of claim 1 or claim 2, wherein the at least one transmissive correction plate further comprises a plurality of adjacent sections, wherein at least one of the plurality of adjacent sections comprises a varying parameter profile.

4. The apparatus of any of claims 1 to 3, wherein at least one of the plurality of adjacent sections comprises a non-varying parameter profile.

5. The apparatus of any preceding claim, wherein when the apparatus comprises two or more transmissive correction plates, said apparatus operable to vary a relative position of at least one of the two or more transmissive correction plates in order to align adjacent sections of each of the two or more transmissive correction plates along an optical axis of the illumination system.

6. The apparatus of claim 5, wherein the relative position of each of the two or more transmissive correction plates is variable in a scanning direction.

7. The apparatus of claim 5 or claim 6, wherein the relative position of the at least one transmissive correction plate is variable in a non-scanning direction.

8. The apparatus of any preceding claim, wherein said varying parameter profile or profiles are configured to counteract an n^{th} order telecentricity variation through slit of radiation transmitted through said at least one transmissive correction plate.

9. The apparatus of any preceding claim, wherein the at least one transmissive correction plate is configured to be rotatable around an optical axis of the illumination system.

10. A method of varying a local angular distribution of radiation using the illumination uniformity correction apparatus of any of claims 1 to 9 comprising:
providing a radiation beam comprising an angular distribution of radiation,
configuring a varying parameter profile of the at least one transmissive correction plate based on the angular distribution of radiation; and
transmitting said radiation beam through the at least one transmissive correction plate of the illumination uniformity correction apparatus.

11. The method of claim 10, further comprising configuring the varying parameter profile of the at least one transmissive correction plate to counteract an n^{th} order telecentricity variation through slit of the radiation beam.

12. The method of claim 10 or claim 11 further comprising,
providing a plurality of transmissive correction plates comprising a plurality of sections, wherein at least one of the plurality of sections comprises a varying parameter profile; and
varying a relative position of at least one of the plurality of transmissive correction plates to align sections of the plurality of transmissive correction plates along an optical axis of the illumination system.

13. The method of claim 12, wherein the varying a relative position is based on the angular distribution of radiation.

14. The method of claim 13, wherein the angular distribution of radiation corresponds to a telecentricity profile of the radiation beam.

15. An illumination system for a lithographic apparatus comprising the illumination uniformity correction apparatus of any of claims 1 to 9.
